# EUROPEAN PATENT APPLICATION

(11) **EP 4 187 613 A2**
(43) Date of publication of application: **31.05.2023**
(21) Application number: 22205205.2
(22) Date of filing: 03.11.2022
(51) Int. Cl.: H01L 29/10, H01L 29/417, H01L 29/423, H01L 21/335, H01L 29/778, H01L 29/20

(54) **LATERAL GALLIUM NITRIDE SUPERJUNCTION**

(30) Priority: 05.11.2021 US 202163276295 P; 25.10.2022 US 202218049543
(71) Applicant: Analog Devices, Inc., Wilmington, MA 01887 (US)
(72) Inventor: FIORENZA, James, Carlisle, 01741 (US); PIEDRA, Daniel, Somerville, 02145 (US); SHTARGOT, Leonard, Campbell, 95008 (US); STEIGERWALD, F. Jacob, North Andover, 01845 (US)
(74) Representative: Horler, Philip John

(57) **Abstract**

A lateral GaN superjunction transistor or switching device that is configured to have higher breakdown voltage and lower on-resistance as compared to other GaN-based switching devices. The lateral GaN superjunction transistor includes a heavily doped buried implant region (hereinafter, "buried implant region") in the substrate underlying the transistor that operates as backside field plate (BFP) to control or reduce gate-drain electric fields at the surface of the transistor, thereby enabling the transistor to operate at higher voltages while reducing charge trapping and breakdown effects. The lateral GaN superjunction transistor operates similarly to a vertical silicon superjunction FET to enable operation of the transistor at higher voltages than other GaN or semiconductor devices, such as to enable the construction of faster or higher power electronic circuits.

## Description

### CLAIM FOR PRIORITY

This application claims priority to U.S. Provisional Application Serial No. 63/276,295, filed November 5, 2021, which is hereby incorporated by reference herein in its entirety.

### FIELD OF THE DISCLOSURE

This document pertains generally, but not by way of limitation, to semiconductor devices, and more particularly, to gallium nitride-based high electron mobility transistors.

### BACKGROUND

Gallium nitride-based semiconductors offer several advantages over other semiconductors as the material of choice for fabricating the next generation of transistors, or semiconductor switching devices, for use in both high-voltage and high-frequency applications. Gallium nitride (GaN) based semiconductors, for example, have wide-bandgaps that enable devices fabricated from these materials to have a high breakdown electric field and to be robust to a wide range of temperatures. The two-dimensional electron gas (2DEG) channels formed by GaN based heterostructures generally have high electron mobility, making devices fabricated using these structures useful in power-switching and amplification circuits.

Figures of merit for switching devices used in power-switching or amplification circuits include the device's on-resistance and gate-to-drain breakdown voltage (hereinafter, "breakdown voltage"). In an example, switching devices having low on-resistance along with a high breakdown voltage generally have better switching performance relative to their switching frequency than devices with higher on-resistance or lower breakdown voltage. Power field effect transistors (FETs) based on superjunction technology have, for at least this reason, supplanted planar FETs as the preferred switching device for high voltage or high-power switching circuits.

### SUMMARY OF THE DISCLOSURE

The present disclosure describes, among other things, a lateral GaN superjunction transistor or switching device that is configured to have higher breakdown voltage and lower on-resistance as compared to other GaN-based switching devices. The lateral GaN superjunction transistor includes a heavily doped buried implant region (hereinafter, "buried implant region") in the substrate underlying the transistor that operates as backside field plate (BFP) to control or reduce gate-drain electric fields at the surface of the transistor, thereby enabling the transistor to operate at higher voltages while reducing charge trapping and breakdown effects. The lateral GaN superjunction transistor operates similarly to a vertical silicon superjunction FET to enable operation of the transistor at higher voltages than other GaN or semiconductor devices, such as to enable the construction of faster or higher power electronic circuits.

In some aspects, this disclosure is directed to a device having a high electron mobility transistor, the device comprising: the high electron mobility transistor, the high electron mobility transistor comprising: a substrate layer; a transmorphically grown gallium nitride (GaN) based heterostructure overlying the substrate layer, the GaN-based heterostructure including: a channel layer of a first compound semiconductor material disposed proximate to the substrate layer; and a barrier layer of a second compound semiconductor material disposed adjacent to the channel layer and forming a two-dimensional electron gas (2DEG) at a junction between the channel layer and the barrier layer, the 2DEG having an electron concentration; and a buried implant region formed by an implanted activated dopant and disposed at least partially within the substrate layer and extending laterally from a region underlying a source terminal of the transistor to a region between a gate and drain terminals of the transistor, the buried implant region configured to modulate an electric field between the gate and drain terminals of the transistor.

In some aspects, this disclosure is directed to a method for forming a high electron mobility transistor, the method comprising: obtaining a substrate; forming, using an ion implantation process, a buried implant region at least partially within the substrate and extending laterally from a region underlying a source of the transistor to a region between a gate and a drain of the transistor; forming a nucleation layer having a crystalline structure presenting a rocking curve with a full width half max below 100 arcseconds; forming a channel layer of a first compound semiconductor material on a surface of the nucleation layer, the channel layer having a second crystalline structure presenting a rocking curve with a peak full width half max below 250 arcseconds; and forming a barrier layer of a second compound semiconductor material on a surface of the channel layer such that a two-dimensional electron gas (2DEG) is formed at a junction between the channel layer and the barrier layer.

In some aspects, this disclosure is directed to a device having a high electron mobility transistor, the device comprising: the high electron mobility transistor, the high electron mobility transistor comprising: a substrate layer; a buried implant region including first and second dopants implanted within the substrate layer, the buried implant region extending laterally from a region underlying a source terminal of the transistor to a region between a gate and drain terminals of the transistor, the buried implant region configured to modulate an electric field between the gate and drain terminals of the transistor; a nucleation layer overlying the substrate and the buried implant region; a channel layer of a first compound semiconductor material overlying the nucleation layer; and a barrier layer of a second compound semiconductor material overlying the channel layer and forming a two-dimensional electron gas (2DEG) at a first interface between the channel layer and the barrier layer; wherein the channel layer and the nucleation layer are transmorphically grown to have a lattice match at a second interface between the nucleation layer and the channel layer that enables a height of the channel layer and the nucleation layer to be smaller than a threshold vertical distance between the buried implant region and the 2DEG to enable the buried implant region to modulate an electric field between the gate and drain terminals.

### BRIEF DESCRIPTION OF THE DRAWINGS

FIG. 1 depicts a cross-sectional diagram of an example of a lateral GaN superjunction transistor having a supported gate structure.
FIG. 2 depicts a cross-sectional diagram of an example of a lateral GaN superjunction transistor including a free-standing gate structure.
FIG. 3 depicts a cross-sectional diagram of an example of a lateral GaN superjunction transistor having a supported gate structure and buried implanted p-type and n-type regions.
FIG. 4 depicts a cross-sectional diagram of an example of a lateral GaN superjunction transistor having a free-standing gate structure and buried implanted p-type and n-type regions.
FIG. 5 depicts a cross-sectional diagram of an example of a lateral GaN superjunction transistor having a supported gate structure and buried implanted p-type and n-type regions.
FIG. 6 depicts a cross-sectional diagram of an example of a lateral GaN superjunction transistor having a free-standing gate structure and buried implanted p-type and n-type regions.
FIG. 7 illustrates an example of a process for forming a lateral GaN superjunction transistor.
FIG. 8 depicts cross-sections of a simulated HEMT formed using conventional techniques and lateral GaN superjunction transistor or transistor 810 formed according to the techniques described herein.
FIG. 9 depicts a cross-sectional diagram of an example of a lateral GaN superjunction transistor having an implanted region and one or more floating implanted regions.
FIG. 10 depicts a cross-sectional diagram of an example of a lateral GaN superjunction transistor having an implanted region that is capacitively coupled to a source.
FIG. 11 illustrates example measurements associated with features of the lateral GaN superjunction transistors or other devices described herein.
FIG. 12 illustrates an example of a lateral GaN superjunction transistor 1200 having an AlN nucleation layer 115 that is formed using hydrogen gas as carrier.

In the drawings, which are not necessarily drawn to scale, like numerals may describe similar components in different views. Like numerals having different letter suffixes may represent different instances of similar components. The drawings illustrate generally, by way of example, but not by way of limitation, various embodiments discussed in the present document.

### DETAILED DESCRIPTION

The present disclosure describes, among other things, a lateral GaN superjunction transistor or switching device that is configured to have higher breakdown voltage and lower on-resistance as compared to other GaN-based switching devices. The lateral GaN superjunction transistor includes a heavily doped buried implant region (hereinafter, "buried implant region") in the substrate underlying the transistor that operates as backside field plate (BFP) to control or reduce gate-drain electric fields at the surface of the transistor, thereby enabling the transistor to operate at higher voltages while reducing charge trapping and breakdown effects. The lateral GaN superjunction transistor operates similarly to a vertical silicon superjunction FET to enable operation of the transistor at higher voltages than other GaN or semiconductor devices, such as to enable the construction of faster or higher power electronic circuits.

Planar silicon FETs, such as lateral FETs constructed using shallow implant wells, typically have high channel and epitaxial layer (hereinafter, "epi layer") resistance. In an example, a planar silicon FET can include source and drain regions formed in p+ wells which are implanted in an n-type epi. Planar silicon FETs typically have relatively high on-resistance and can suffer from device reliably issues when operated at high voltages due to the nonuniform distribution of electric fields near the device surface. These electric fields can, for example, include peaks that degrade the operation of the device overtime. Such nonuniformity can be caused by uneven depletion of n-type and p-type regions in the device. Vertical super junction silicon FETs include deep implant wells, such as p-type wells that extend deep into an n-type well or substrate. The deep wells enable a more uniform depletion of the p-type and n-type regions in the device, thereby generating flatter or more uniform electric fields in response to the application of high voltage signals, such as a high source-drain voltage. This improves the operation of the device by reducing the number electric field peaks and moving such peaks into the body of the device, enabling the device to operate at higher voltages than planar devices. Other improvements include reduced on-resistance and gate charge.

Fabricating superjunction GaN devices using the deep well techniques used to fabricate vertical super junction silicon FETs may not be practical due to the difficulty in forming activated p-type implants in a GaN epi. In an example, p-type dopants for GaN have activation energies that are so high that it is difficult to activate the implanted dopants without risking damage to the GaN epi. Additionally, the poor mobility of p-type dopants for GaN makes it infeasible to use such material to form a well-functioning superjunction transistor using only GaN.

Examples of the present disclosure are based on the inventors' recognition that a GaN transistor or other GaN switching device can be configured with a buried implant region that is implanted and patterned in a substrate to enable the device to operate as, or to mimic the functionality of, a superjunction transistor. Such a device is referred to herein as a lateral GaN superjunction transistor as its operation can be analyzed by considering the operation of a vertical superjunction silicon FET that is turned on its side, such that the deep p-wells of the superjunction silicon FET are disposed laterally in the n-type epi. In this case the buried implant region of the lateral GaN superjunction transistor exhibits the behavior of the deep p-wells of the superjunction silicon FET. Forming the buried implant region in the device substrate overcomes or eschews the issues associated with forming deep p-wells in a GaN epi.

In an example, a lateral GaN superjunction transistor is formed using a GaN epi layer grown on a substrate, such as silicon carbide substrate (SiC). The substrate is implanted with a p-type dopant and the dopant is activated to form a buried activated implanted region (hereinafter, "implanted region" or "buried implant region"). In another example, the buried implant region is formed by implanting the substrate with a p-type dopant and an n-type dopant and activating each dopant to form an activated p-type region and an activated n-type region. In an example, the implanted region is masked and patterned to have an indicated geometry or shape. In an example, the implant region is patterned such that a first portion of the GaN epi is grown on a surface of the substrate and a second portion of the GaN epi is grown on a surface of the buried implant region. In an example, the GaN epi is grown by forming a nucleation or transition layer on a surface of the substrate and the buried implant region. The nucleation layer can include one or more layers of nucleation material, such as aluminum nitride, that is configured to provide a lattice transition between the lattice structure of the substrate, the implanted region and the GaN epi. The GaN epi is then grown on the nucleation layer by growing a channel layer, such as a layer of unintentionally doped GaN, and a barrier layer, such a layer of aluminum gallium nitride (AlGaN), such that a 2DEG is formed at the interface of the channel layer and the barrier layer. Gate, source, and drain contacts are made to the 2DEG at the interface of channel and barrier layers. A hole is then etched through the GaN epi and the buried implant region is contacted, such as by a device body contact. In some examples, the source contact is extended to contact the buried implant region.

The buried implant region can operate as a BFP, such as when the distance between the implanted region and the 2DEG formed by the channel and barrier layers of the GaN epi is small enough such that the electric field, or electric field spikes, generated in the lateral GaN superjunction transistor can be controlled or shaped by the implanted region. Operation of the buried implant region as a BFP can minimize electric field peaks which can cause charge trapping, device breakdown, and other reliability or performance issues. In an example, the distance between the buried implant region and the 2DEG (e.g., the thickness or height of the combined nucleation layer and channel layer) is between 200 and 400 nanometers (nm).

GaN devices typically include an epi layer that is larger than 1 micrometer (um) or where the distance between the substrate and the 2DEG exceed 400 nanometers. In some examples, a typical epi layer is approximately 1.3um. The lower limit on the size of a GaN epi layer, such as a GaN channel layer, is at least partially determined by the growth of the epi on the non-GaN substrate. Lattice mismatch at the interface between the GaN epi and the nucleation layer, or between the nucleation layer and the substrate, can cause dislocation defects that result in charge trapping that degrade the performance of the GaN epi or of GaN devices fabricated using the epi. The dislocation defects, or the effect of the dislocation defects, decrease with increased size of the epi layer, therefore a minimum epi layer height or thickness may be prescribed to obtain suitable GaN device performance. In an example, the lower limit of a GaN layer proximate the substrate or nucleation layer may be limited to 400nm to cause the GaN to have a crystalline quality that limits trapping to an acceptable level. In view of these prescribed height or thickness limits, it may not be practical to make an effective lateral GaN superjunction transistor using GaN epi that is grown using standard techniques as the distance between the buried implant region of the device and the 2DEG may be too large.

Aspects of the present disclosure are based on the inventors' realization the GaN epi height or thickness limitations associated with typical GaN devices can be overcome by growing the GaN epi using transmorphic epitaxy, such as described in "Transmorphic epitaxial growth of AIN nucleation layers on SiC substrates for high-breakdown thin GaN transistors" by Jun Lu et al, which is included herein by reference. In an example, transmorphic epitaxy is used to reduce or suppress defects in an AlN nucleation layer by transforming the lattice configuration of a SiC substrate to the configuration of an AlN nucleation layer using only a 1nm thick transition. This enables the formation of a thin (e.g., less than 10nm-50nm) AlN nucleation layer with few dislocation or lattice mismatch defects, which in turn enables the growth of thin GaN epi with reduced defects or charge trapping. In an example, a GaN device having a GaN epi grown according to these techniques can include a nucleation layer having a thickness of 10-50nm and a crystalline structure presenting a rocking curve with a peak full width half max (FWHM) below 100 arcseconds as measured by x-ray diffraction. The GaN epi may include a GaN channel layer having a thickness as small as 150nm with a crystalline structure presenting a rocking curve with a peak FWHM below 300 arcseconds. Such GaN epi layer can exhibit a critical breakdown field of up to 2MV/cm. In a case where the GaN device is formed as a lateral GaN superjunction transistor, the distance between the buried implant region and the 2DEG of a lateral GaN superjunction transistor fabricated using this epi is small enough (e.g., less than 400nm) for the implanted region to operate as an effective BFP, as described herein. In an example such distance is 100-200nm, 200-400nm, or 300-400nm.

In operation, the lateral GaN superjunction transistors described herein work similarly to a vertical silicon superjunction FET. A voltage applied to the drain (e.g., a voltage applied between the source and drain) of the lateral GaN superjunction transistor vertically depletes the activated dopants in the device buried implanted region of the substrate (e.g., the activated p-type dopants) which depletes the 2DEG at the interface of the channel and barrier layers. As the drain voltage is increased, the 2DEG and buried implanted substrate (e.g., the activated p-type SiC) are further depleted until each is completely depleted. In an example, the concentration of activated dopants in the buried implanted layer matches the concentration of electrons in the 2DEG such that the implanted layer and the 2DEG are depleted of charge carriers at the same time or according to an indicated or desired rate relative to each other. After the charge carriers in the buried implant region and the 2DEG are depleted, the drain voltage can continue to rise. As the drain voltage rises, the electric field in the device is reduced compared to a device without a backside field plate (e.g., the buried implanted region). The field is reduced such that the field profile is smooth, and peaks are reduced or eliminated in a direction from the gate to the drain. In an example, the electric field is also dropped within the body of the lateral GaN superjunction transistor (e.g., at or near an interface of the BFP and the substrate) away from the surface of the device near the gate or drain. The overall result includes an increased breakdown voltage, such as enabled by the reduced electric field that is dropped in the body of the transistor, and lower on resistance as compared with other GaN devices or technologies.

Examples of the present disclosure include lateral GaN superjunction transistors or switching devices formed using compound semiconductor materials. Such compound semiconductor materials may include a chemical compound of elements from different groups in the periodic table. Such chemical compounds may include a pairing of elements from group 13 (i.e., the group comprising boron (B), aluminum (Al), gallium (Ga), indium (In), and thallium (Tl)) with elements from group 15 (i.e., the group comprising nitrogen (N), phosphorus (P), arsenic (As), antimony (Sb), and bismuth (Bi)). Group 13 of the periodic table may also be referred to as Group III and group 15 as Group V. Without limitation, a semiconductor device may be fabricated from gallium nitride (GaN) and aluminum indium gallium nitride (AlInGaN). Additionally, a semiconductor device may be fabricated using aluminum nitride (AlN)/GaN/AlN hetero-structures, indium aluminum nitride (InAlN)/GaN, GaN/aluminum GaN (AlGaN), or other combinations of group 13 and group 15 elements. These hetero-structures may form a two-dimensional electron gas (2DEG) at the interface of the compound semiconductors that form heterostructure, such as the interface of GaN and AlGaN. The 2DEG may form a conductive channel of electrons that may be controllably depleted, such as by an electric field formed by a gate terminal disposed above the channel, to control a current through the semiconductor device. In an example, the semiconductor device may be a field effect transistor, such as a high electron mobility transistor (HEMT), having source and drain terminals electrically coupled to a channel formed by a 2DEG, and a gate terminal disposed above the channel. A voltage on the gate terminal, determined relative to a voltage on the drain terminal, may induce an electric field into the channel to control the concentration of free electrons in the 2DEG, such as to control a flow of current through the transistor.

Examples of the present disclosure include avalanche robust lateral GaN superjunction transistors or switching devices. In such examples, the buried implant layer of the lateral GaN superjunction transistor includes an n-type dopant that provides a path for charge or electric current to flow from the drain of the transistor to the source during an overvoltage condition, such as when a voltage at the drain exceeds a threshold voltage, such as caused by a charge build-up at the drain. The buried implant layer may also include a p-type dopant that operates as a barrier to limit leakage current.

Examples of the present disclosure include a lateral GaN superjunction transistor having a free-standing gate, such as a T-gate. In such examples, the buried implant layer of the lateral GaN superjunction transistor operates as a field plate to control the electric field at the surface of the transistor, such as the electric field between the gate and drain, or the electric field between the source and drain.

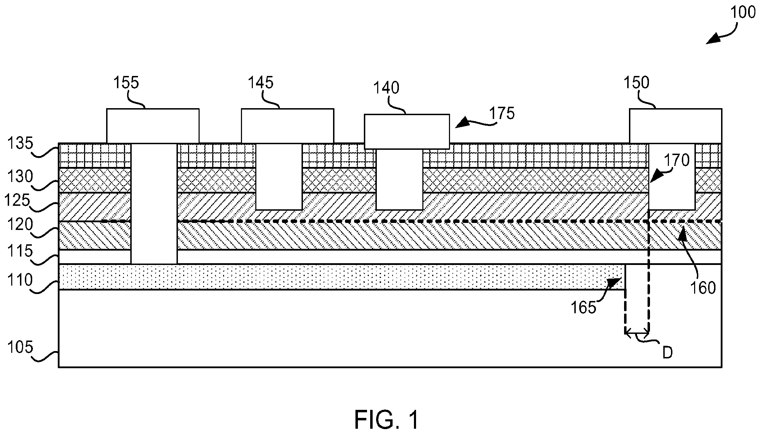

FIG. 1 depicts a cross-sectional diagram of an example of a lateral GaN superjunction transistor 100 having a supported gate structure. GaN superjunction transistor 100 is an example of one or more of the GaN superjunction transistors described herein. In an example, GaN superjunction transistor 100 includes substrate layer 105, buried implant region 110, nucleation layer 115, a heterostructure formed by channel layer 120 and barrier layer 125, and capping layers 130 and 135. In some examples, GaN superjunction transistor 100 further includes gate contact 140, source contact 145, drain contact 150, and body contact 155.

The substrate layer 105, in various examples, is a wafer, such as a wafer of a high-quality monocrystalline semiconductor material, such as sapphire (α-A1203), GaN, GaAs, Si, SiC in any of its polymorphs (including wurtzite), AlN, InP, or similar substrate material used in the manufacture of semiconductor devices. Such substrate may be received from a prior fabrication process or it may be produced according to one or more substrate growth and processing techniques. In the examples described herein, substrate layer 105 is referred to as a SiC substrate for ease of discussion. Other substrates may be used to fabricate the lateral GaN superjunction transistor 100.

Buried implant region 110, in various examples, includes a region of substrate layer 105 implanted with n-type dopants, such as a nitrogen or phosphorus n-type dopant, or one or more p-type dopants, such as beryllium, boron, aluminium, or gallium. In an example, substrate layer 105 can be processed to form buried implant region 110 by forming a mask on the surface of the substrate, where the mask is patterned to have a desired geometry (e.g., desired or indicated shapes or dimensions) of the of the implanted region. A dopant, such as a p-type dopant, can then be implanted, such as by using an ion implantation process or other suitable processes, into areas of substrate layer 105 that are exposed by the mask. The implanted dopants can then be electrically activated. In another example, substrate layer 105 can be processed to form a buried implant region 110 by implanting a dopant, such as a p-type dopant, over a region of the substrate without using a mask. A mask can then be formed over the portions of the implanted region, where the mask is patterned to have a desired geometry (e.g., desired or indicated shapes or dimensions) of the of the implanted region. The mask can then be used to activate or deactivate dopants in portions of the implanted region.

In some examples, the buried implant region 110 activated dopant concentration (e.g., the concentration of dopant atoms or charge carriers that are electrically activated) is matched to the concentration of electrons in the 2DEG 160. In an example, the activated dopant concentration is matched to the concentration of electrons in the 2DEG 160 when the concentration of activated dopant atoms or ions (e.g., the number of activated dopant atoms or charge carriers per unit area) is equal, within an indicated margin of error, to the concentration of electrons in the 2DEG. In another example, the activated dopant concentration is matched to the concentration of electrons in the 2DEG 160 when the concentration of activated dopant atoms or ions is offset from the concentration of electrons in the 2DEG by an indicated amount, such as indicated by a numeric constant or a mathematical function or relationship. In another example, the activated dopant concentration is matched to the concentration of electrons in the 2DEG 160 such that a voltage applied to drain 150 depletes charges in the buried implant region 110 at the same time or at the same rate as it depletes charge carriers or electrons in the 2DEG 160.

In an example, buried implant region 110 extends laterally under body contact 155, source contact 145, and gate 140 to a region between gate 140 and drain 150. In an example, buried implant region 110 extends laterally from at least a region under body contact 155 to a distance towards drain contact 150 such that an edge 165 of buried implant region 110 closest to drain contact 150 is a distance D between from an edge 170 of the drain contact that is closest to edge 165. In an example, distance D is at least half the lateral distance between gate 140 and drain 150. In another example, the distance D is between 70% and 99% of the distance between gate 140 and drain 150. In yet another example, distance D is at least partially determined to enable the activated dopants in BFP 110 to deplete at substantially the same time as electrons in the 2DEG overlying BFP 110 deplete. In some examples distance D is determined experimentally or specified based on one or more design requirements.

Nucleation layer 115, in various examples, includes one or more layers of epitaxially grown nucleation or lattice transition layers. Nucleation layer 115 can help or facilitate epitaxial growth of one or more layers of semiconductor materials, such as GaN or channel layer 120. In an example, Nucleation layer 115 is formed or grown on the substrate layer 105 and buried implant region 110 using transmorphic epitaxy such that the nucleation layer has a high-quality crystalline structure presenting a rocking curve with a peak FWHM below 100 arcseconds as indicated by x-ray diffraction. In an example, nucleation layer 115 has a height or thickness of 10nm to 50nm. In an example, nucleation layer 115 is an AlN nucleation layer that is formed or grown by transmorphic epitaxy and having a height or thickness of 10nm to 50nm.

Channel layer 120, in various examples, includes a GaN, AlGaN, or another compound semiconductor layer that is formed or grown on nucleation layer 115 using transmorphic epitaxy such that the channel layer has a high-quality crystalline structure presenting a rocking curve with a peak FWHM below 300 arcseconds as indicated by x-ray diffraction. In certain examples, channel layer 120 is a GaN layer grown or formed using transmorphic epitaxy. In an example, channel layer 120 has a height or thickness of 100-350nm. In certain examples, channel layer 120 has a height or thickness of 150nm within an acceptable margin of error.

The thickness of the nucleation layer 115 or channel layer 120 can be selected or determined such that the distance between buried implant region 110 (e.g., a top surface of Buried implant region 110) and 2DEG 160 is small enough to enable buried implant region 110 to operate as a BFP as described herein. In an example, combined height or thickness of nucleation layer 115 and channel layer 120, within an acceptable margin of error, is between 100nm and 400nm.

Barrier layer 125, in various examples, includes a GaN, AlGaN, or another compound semiconductor layer that is formed or grown on channel layer 120 such that 2DEG 160 is formed at the interface between the barrier layer and the channel layer. In an example, barrier layer 125 is an AlGaN layer that is epitaxially grown on a GaN channel layer to form the 2DEG 160.

The capping layer formed by layers 130 and 135 can include one or more passivation layers or oxide layer. In an example, layer 130 is a layer of GaN material (e.g., unintentionally doped GaN) and layer 135 is a layer of Silicon Nitride (SiN). In an example, layer 130 is configured to support (e.g., to provide vertical structural support) the head 175 of gate 140 (e.g., a T-gate).

Gate 140 can be any electrically conductive material selected to bias or control lateral GaN superjunction transistor 100. In an example, gate 140 is configured as a T-gate including head 175. In another example, gate 140 includes a frontside field plate that is supported by head 175 and layer 135.

Source contact 145 and drain contact 150 can be any suitable electrically conductive material capable of forming an ohmic contact or other electrically conductive junction with 2DEG 160.

Body contact 155 can be any suitable electrically conductive material capable of forming an ohmic contact or other electrically conductive junction with buried implant region 110.

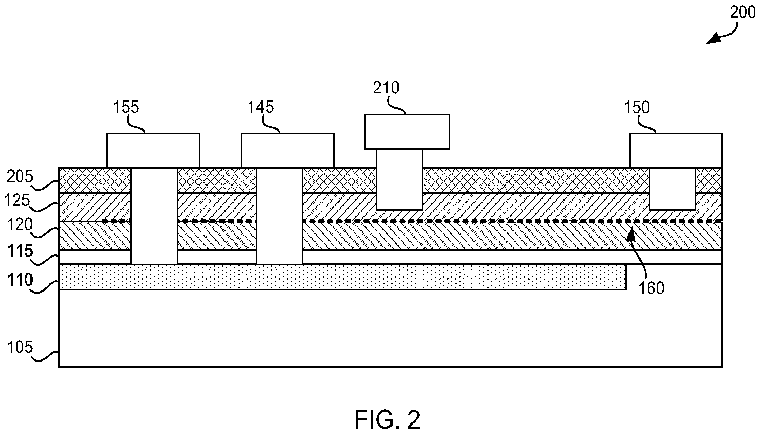

FIG. 2 depicts a cross-sectional diagram of an example of a lateral GaN superjunction transistor 200 including a free-standing gate 210. Lateral GaN superjunction transistor 200 is an example of lateral GaN superjunction transistor 100 (FIG. 1), modified such that gate 210 is not supported by a passivation or dielectric layer, such as layer 135. In an example, layer 205 corresponds to layer 130 and may be modified to have a greater height or thickness than layer 130.

In an example, free-standing gate 210 is a T-gate that is not supported by a dielectric. This configuration of the gate has the effect of reduced gate capacitance, which is particularly adapted to for high frequency switching circuits or devices.

The absence of structural support for free-standing gate 210 inhibits that ability to fabricate a front side field plate on lateral GaN superjunction transistor 200. The frontside field plate cannot be formed or fabricated on the switching device because of the lack of vertical support by a dielectric or passivation layer. Buried implant region 110 compensates for the absence of the frontside field plate by enabling control of the electric field between the gate 210 and drain 150 as described herein.

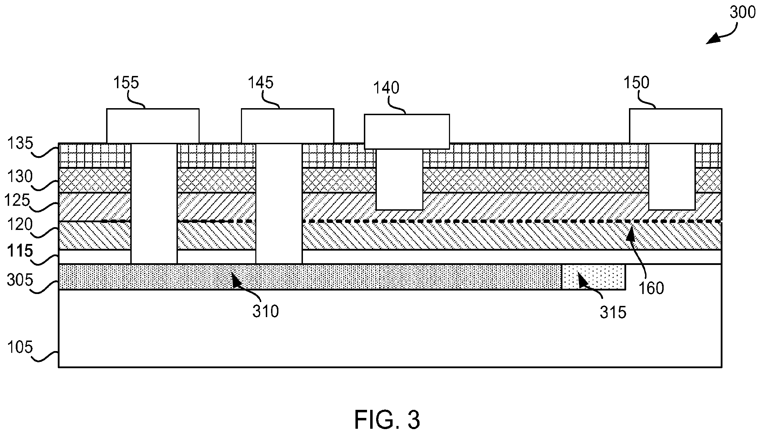

FIG. 3 depicts a cross-sectional diagram of an example of a lateral GaN superjunction transistor 300 having a supported gate 140 and buried implanted p-type and n-type regions. Lateral GaN superjunction transistor 300 is an example of lateral GaN superjunction transistor 100 (FIG. 1), modified such that buried implant region 305 corresponding to buried implant region 110 includes an implanted n-type region 310 and an implanted p-type region 315. Buried implant region 305 is configured to operate as a BFP, such as described in the discussion of buried implant region 110.

N-type region 310 is a region of substrate layer 105 that is doped, patterned, and activated, using an n-type dopant. N-type region 310 includes higher mobility charge carriers (e.g., electrons) and a has a higher dopant activation than p-type region 315 or the p-type material of buried implant region 110. Accordingly, n-type region 310 is more conductive than p-type region 315 or the p-type material of buried implant region 110. The greater conductivity of n-type region 310 improves the performance of buried implant region 305 at high switching frequencies.

In an example, source contact 145 or body contact 155 can contact n-type region 310. Source contact 145 or body contact 155 can be formed using the same metal as drain 150, as opposed to the case in FIG. 1 where different materials or different processes are needed to contact the p-type buried implant layer.

In an example, n-type region 310 enables lateral GaN superjunction transistor 300 to operate as an avalanche robust transistor, such as by providing a path through the n-type region for current to flow from drain 150 to source contact 145 or body contact 155 responsive to a current or charge build-up at the drain that causes a drain voltage exceeds an indicated threshold voltage level. This can inhibit or prevent a charge build which can otherwise damage or destroy the switching device.

P-type region 315 is a region of substrate layer 105 that is doped, patterned, and activated, using a p-type dopant, such as described in FIG. 1. The lateral width or the activated p-type dopant concentration can be selected to control avalanche response of lateral GaN superjunction transistor 300, such as by tuning or adjusting the threshold voltage at which the switching device begins to conduct current through the n-type region 310. P-type region 315 is configured to block current leakage through the buried implant layer 305.

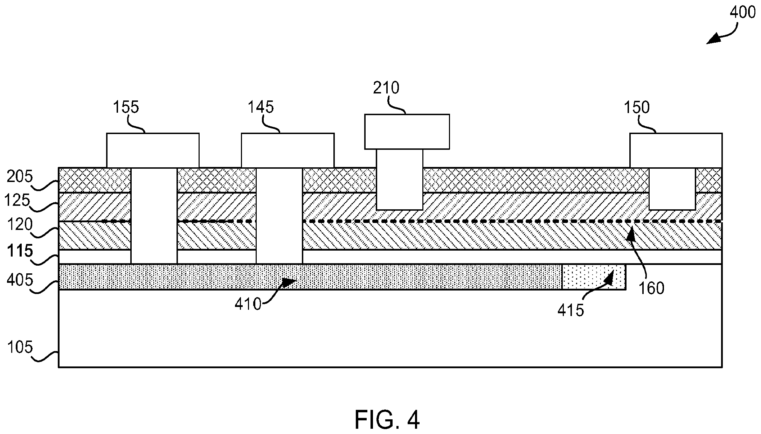

FIG. 4 depicts a cross-sectional diagram of an example of a lateral GaN superjunction transistor 400 having a free-standing gate and buried implanted p-type and n-type regions. Lateral GaN superjunction transistor 400 is an example of the lateral GaN superjunction transistor 200 (FIG. 2), modified such that buried implant region 405, corresponding to buried implant region 110, includes implanted n-type region 410 and implanted p-type region 415, corresponding to n-type region 310 and implanted p-type region 315, as showing in FIG. 3. In an example, n-type region 410 and p-type region 415 are formed using the same process and provide the same functionality as implanted n-type region 310 and implanted p-type region 315.

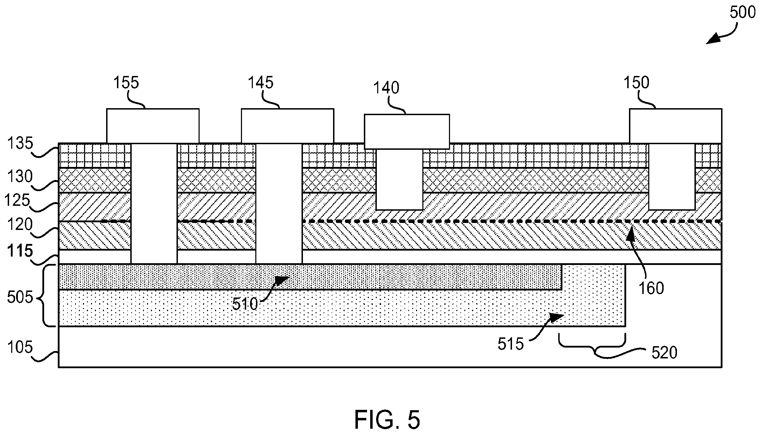

FIG. 5 depicts a cross-sectional diagram of a lateral GaN superjunction transistor 500 having a supported gate structure and buried implanted p-type and n-type regions. Lateral GaN superjunction transistor 500 is an example of lateral GaN superjunction transistor 300 (FIG. 3), modified such that buried implant region 505 corresponding to buried implant region 405 includes an implanted n-type region 510 and an implanted p-type region 515. Buried implant region 305 is configured to operate substantially the same as buried implant region 305. As shown in FIG. 5, n-type region 510 is formed within a region of p-type region 515. In an example, buried implant region 505 is formed by implanting a p-type dopant into a region of substrate layer 105 followed by implanting an n-type dopant into a region of the implanted p-type dopant. The p-type dopants in at least a region 520 and the n-type dopants are then activated.

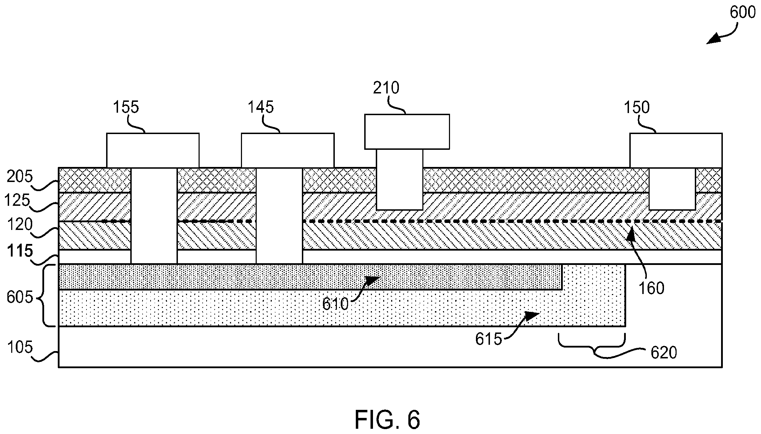

FIG. 6 depicts a cross-sectional diagram of an example of a lateral GaN superjunction transistor 600 having a free-standing gate structure and an implanted p-type and n-type region. Lateral GaN superjunction transistor 600 is an example of the lateral GaN superjunction transistor 400 (FIG. 4), modified such that the buried implant layer 605 corresponding to buried implant region 405 includes an implanted n-type region 610 and an implanted p-type region 615. Buried implant region 605 is configured to operate substantially the same as buried implant layer 405. As shown in FIG. 6, n-type region 610 is formed within a region of p-type region 615. In an example, buried implant layer 605 is formed by implanting a p-type dopant into a region of substrate layer 105 followed by implanting n-type dopants into a region of the implanted p-type dopants. The p-type dopants in at least region 620 and the n-type dopants are then activated.

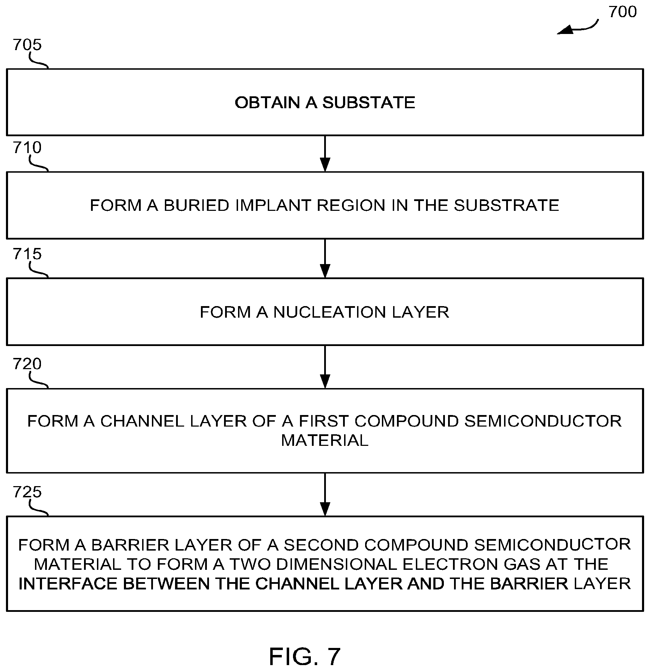

FIG. 7 illustrates an example of a process 700 for forming a lateral GaN superjunction transistor, such as any of the lateral GaN superjunction transistor depicted in, or described in association with, FIGS. 1-6. The process 700 can be used to fabricate any other depletion mode or enhancement mode device described herein.

The process 705 can begin by receiving a substrate having a substantial crystalline structure. Such substrate can be received from a prior fabrication process or it can be produced according to one or more substrate growth and processing techniques. Such substrate can be a wafer, such as a wafer of sapphire (α-A1203), GaN, GaAs, Si, SiC in any of its polymorphs (including wurtzite), AlN, InP, or similar substrate material used in the manufacture of semiconductor devices. In an example, the obtained substrate is a SiC substrate.

At 710, a buried implant region is formed in a region of the substrate. In an example, the buried implant region is buried implant region 110 (FIG. 1), 305 (FIG. 3), 405 (FIG. 4), 505(FIG. 5), or 605 (FIG. 6). In an example, the buried implant region is formed at least partially within the substrate layer and extends laterally from a region underlying a source terminal of the switching device to a region between gate and drain terminals of the switching device. The buried implant region can be formed by implanting, such as by using an ion implantation technique, one or more dopants into the region of the substrate as described herein.

At 715, a nucleation layer, such as nucleation layer 115, is formed over or on a surface of the substrate and the buried implant region. In an example, the nucleation layer is formed to using transmorphic epitaxy to have a crystalline structure presenting a rocking curve with a peak FWHM below 100 arcseconds, as described herein. In an example, forming the nucleation layer includes using nitrogen as a carrier gas, such as to deliver an organic Al source to a reaction chamber used to form the nucleation layer.

At 720, a channel layer, such as channel layer 120, of a first compound semiconductor material is formed. In an example, the channel layer includes a heteroepitaxial GaN thin-film, such as thin-film formed by transmorphic epitaxy, or by using another thin-film formation technique, such as chemical vapor deposition (CVD), such as to have a thickness between 50nm and 100nm. In an example, the channel layer is formed using transmorphic epitaxy to have a crystalline structure presenting a rocking curve with a peak FWHM below 300 arcseconds.

At 725, a barrier layer, such as barrier layer 125, of a second compound semiconductor material is formed on the channel layer. The barrier layer can be formed by epitaxial growth or using another thin-film formation technique. In an example, the first compound semiconductor material and the second compound semiconductor material are selected to have different bandgaps, such as to form a heteroj unction at the interface between the channel layer and the barrier layer, which enables a 2DEG, such as 2DEG 160, to form at the heteroj unction.

In an example, forming the nucleation layer at 715 or forming the channel layer at 720 includes forming the nucleation layer or forming the channel layer such to have a combined height or thickness such that the vertical distance between the buried implant region and the 2DEG is between 150nm and 400nm.

In an example, forming the buried implant region at 710 includes forming the buried implant region to such that the buried implant region has an activated dopant concentration that is matched to an electron concentration of the 2DEG, as described herein.

In an example, forming the buried implant region at 710 includes forming a p-type region by implanting a p-type dopant into the substrate and forming an n-type region by implanting an n-type dopant into the substrate. In an example, forming such n-type region includes forming the n-type region laterally adjacent to the p-type region. In another example, forming such n-type region includes forming the n-type region at least partially within the p-type region so that the n-type region laterally overlies a length of the p-type region.

In an example, process 700 includes forming source or source contact of the switching device such that the source contacts the n-type dopant in the buried implant layer. Such as source or source contact can be formed using the same material or the same process used to from the drain contacts.

In an example, process 700 includes forming a gate, such as a T-gate, having a free-standing gate head.

In an example, process 700 can includes one or more of the steps described herein for forming any of the described or depicted lateral GaN superjunction transistor depicted.

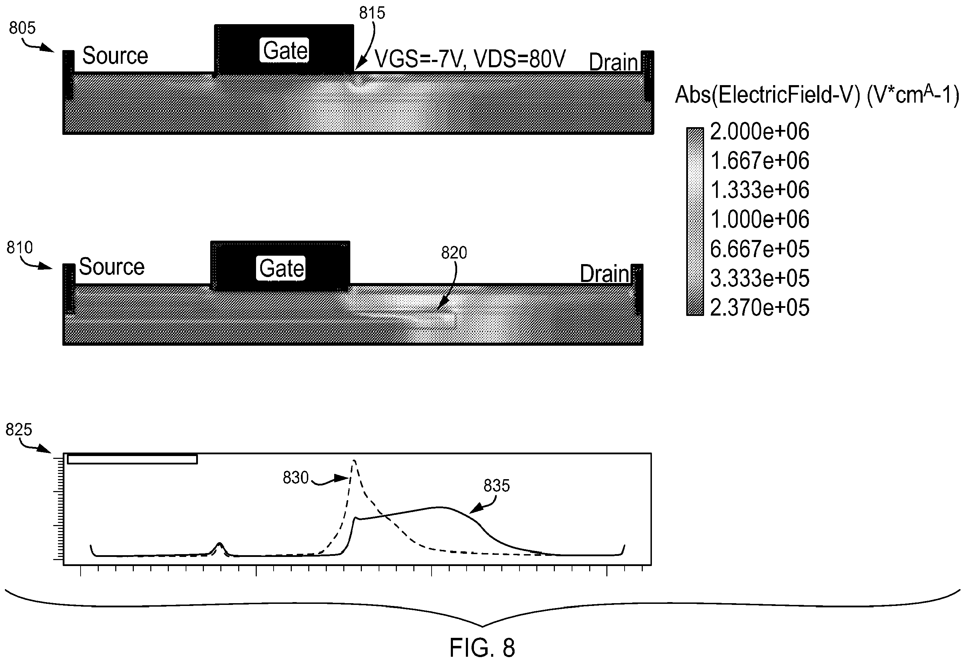

FIG. 8 depicts cross-sections of a simulated HEMT 805 formed using conventional techniques and lateral GaN superjunction transistor or transistor 810 formed according to the techniques described herein. As showing in the figures, electric field intensity is highest near the top surface of HEMT 805 at an interface between the gate and one or more adjacent device layers. This high field intensity near the surface of the device can degrade or damage the HEMT over time. As showing in the figure, electric field intensity is pulled away from the surface of lateral GaN superjunction transistor or transistor 810 to a region within the body of the transistor by the buried implant layer. This reduces electric field peaks near the top surface of the transistor, thereby improving device performance and reducing the likelihood of damage. Graph 825 depicts a plot of electric field intensity as a function of lateral position across the HEMT 830 and lateral GaN superjunction transistor or transistor 835. The plots illustrate reduction in electric field peaks in the lateral GaN superjunction transistor or transistor caused by the buried implant layer.

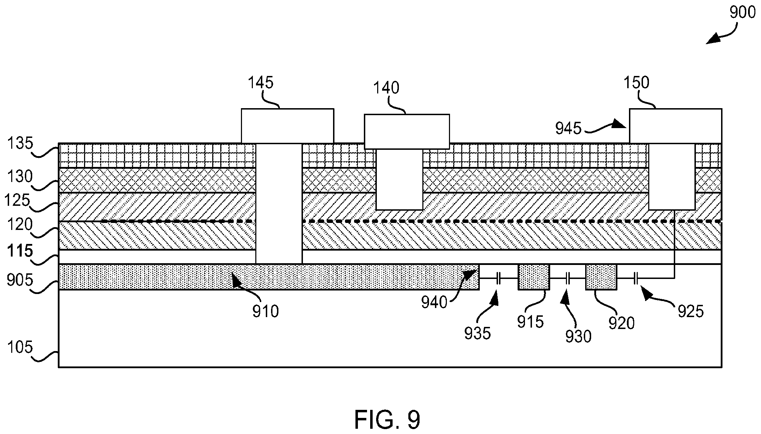

FIG. 9 depicts a cross-sectional diagram of an example of a lateral GaN superjunction transistor 900 having an implanted region 910 and one or more floating implanted regions 915 or 920. Lateral GaN superjunction transistor 900 is an example of one or more of the previously described lateral GaN superjunction transistors, modified such that the buried implant layer 905 includes implanted region 910 and floating implanted region 915 or 920. Implanted region 910 forms a backside field plate that is coupled (e.g., physically connected or electrically) to source contact 145. Floating implanted regions 915 or 920 include one or more implanted regions that are spaced apart from each other and from implanted region 910 and drain 150. In an example, floating implanted regions 915 or 920 are interposed between an edge 940 of implanted region 910 and an edge 945 of drain 150. Implanted region 910 and floating implanted regions 915 or 920 can be formed according to any of the techniques described herein for forming an implanted region. Such techniques can further include forming floating implanted regions 915 or 920 by using a patterning or dopant activation step that physically or electrically isolates the floating implanted regions from each other and from implanted region 910, as shown in FIG. 9. In an example, the lateral distances between edge 940, floating implanted regions 915 or 920, and edge 945, are individually or collectively selected or indicated to provide an indicated capacitance 925, 930, or 935 between the floating implanted regions and implanted region 910 or drain 150. In another example, the size (e.g., geometry, shape, area, or volume) of the floating implanted regions 915 or 920 are individually or collectively selected or indicated to provide an indicated capacitance 925, 930, or 935 between the floating implanted regions and implanted region 910 or drain 150. In yet another example, such lateral distances and sizes are individually or collectively selected or indicated to provide an indicated voltage drop at each floating implanted region 915 or 920.

In operation, implanted region 910 operates as a backside field plate to control the electric field within lateral GaN superjunction transistor 900 as described in the discussion of the preceding devices. Floating implanted regions 915 or 920 operate as capacitive voltage dividers, such as formed by parasitic capacitance 925, 930, or 935. The capacitive voltage divider shapes the electric field within lateral GaN superjunction transistor 900 by incrementally dropping, at each floating implanted region, a voltage coupled from drain 150 to implanted region 910, thereby providing a smooth or controllable electric field profile or transition within the transistor. In an example, the capacitive voltage divider can shape an electric field generated by a 50V signal applicated to drain 150 by providing a 20V drop between the drain and floating implanted region 920, a 15V drop between floating implanted region 920 and floating implanted region 915, and a 7V or 8V drop between floating implanted region 915 and implanted region 910. This technique, in various examples, provides improvements over techniques that use one or more frontside field plates to shape an electric field in a transistor.

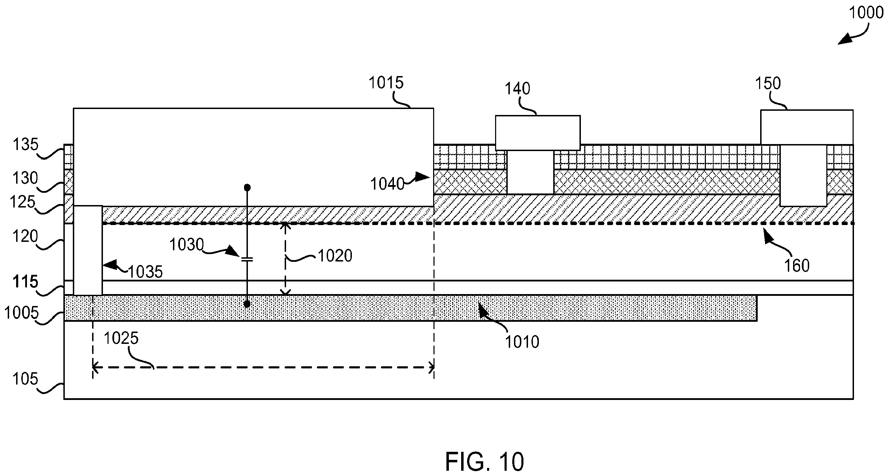

FIG. 10 depicts a cross-sectional diagram of an example of a lateral GaN superjunction transistor 1000 having an implanted region 1010 that is capacitively coupled to a source 1015. Lateral GaN superjunction transistor 1000 is an example of one or more of the previously described the lateral GaN superjunction transistors, modified such that buried implant layer 1005 includes an implanted region 1010 which is capacitively coupled to source 1015. In an example, implanted region 1010 is physically or electrically isolated from source 1015, such as when lateral GaN superjunction transistor 1000 is switched at frequency below an indicated or target frequency range. In another example, implanted region 1010 is physically or electrically isolated from source 1015 or lateral GaN superjunction transistor 1000 except for a source contact 1035 disposed at least an indicated distance 1025 away from edge 1040 of source 1015 or at an indicated distance away from the transistor. Distance 1025 is selected or determined such that the resistance or electrical impendence between implanted region 1010 and contact 1035 is larger than a capacitive electrical impedance between implanted region 1010 and source 1015, such as when lateral GaN superjunction transistor 1000 is switched at an indicated frequency or within an indicated frequency range. In an example, the indicated frequency or the indicated frequency range depends on, or is associated with, the distance 1020 between source 1015 and implanted region 1010, such that the frequency increases or decreases, respectively, with an increase or decrease in the length of distance 1020. In example, the distance 1020 is approximately 200nm and the indicated frequency range is around 5GHz.

In operation, implanted region 1010 is capacitively coupled to source 1015, such as by parasitic capacitance 1030, when lateral GaN superjunction transistor 1000 is switched at an indicated frequency or within an indicated frequency range (e.g., around or above 50GHz).

In an example, the device shown in FIG. 10 provides improvements over other devices, such as 1) fabrication using a simplified process that may not require a via etch to physically connect source 1015 to implanted region 1010, or 2) a switching performance that is not limited by a resistance between implanted region 1010 and a contact resistance between source 1015 and implanted region 1010.

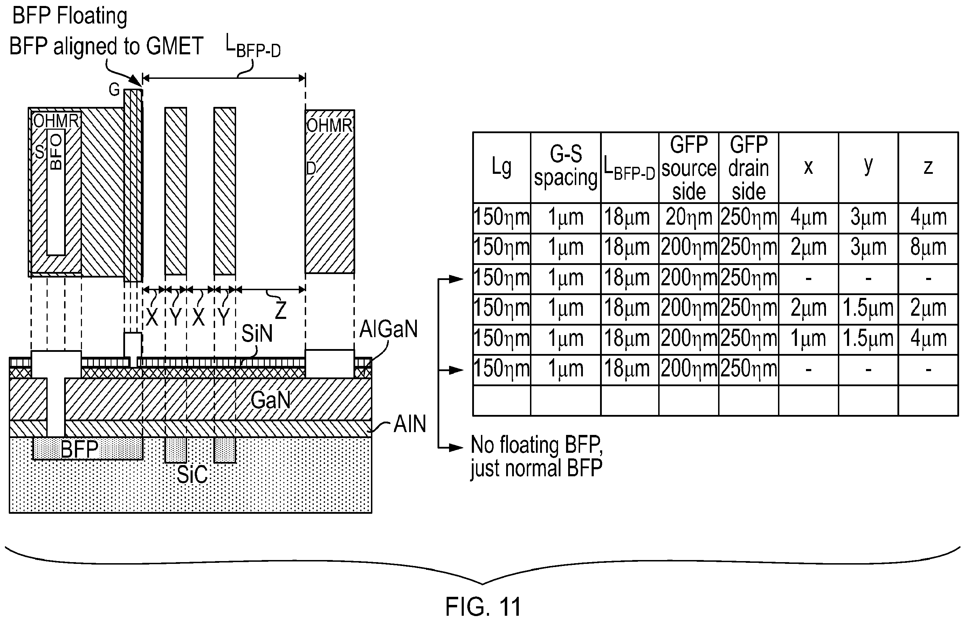

FIG. 11 illustrates examples example geometries, sizes, measurements or distances (hereinafter, referred to collectively as "measurements") associated with features of the lateral GaN superjunction transistors or other devices described herein. Such measurements include a gate length Lg, gate to source spacing (G-S spacing), a length or distance between an implanted region or buried backside field plate and drain (LBFP-D), a distance x between implanted regions, a width y of floating implanted regions, and a distance z between a drain and a proximate floating implanted region.

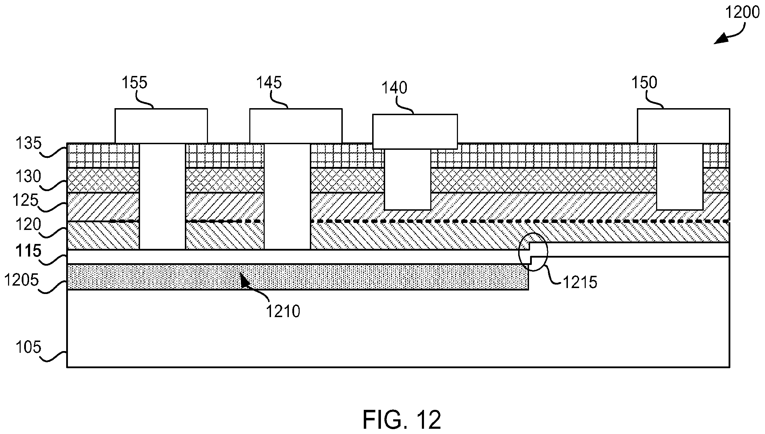

FIG. 12 illustrates an example of a lateral GaN superjunction transistor 1200 having an AlN nucleation layer 115 that is formed using hydrogen gas during the temperature ramp up prior to the epi growth, such as in a process that uses a hydrogen bubbler to introduce an organic metal source to a reaction chamber to form the AlN layer. Lateral GaN superjunction transistor 1200 includes a buried implanted layer 1205 having implanted region 1210 corresponding to the implanted regions previously described herein. The ion implant step used to form implanted region 1210 in SiC substrate layer 105 can damage regions of the substrate. Subsequently, during the high temperature growth of AlN nucleation layer 115 or GaN/AlGaN channel layers 120 and 125, the damaged SiC can be desorbed, forming a step 1215 in the lateral GaN superjunction transistor 1200. Hydrogen gas used in the ramp up prior to the AlN growth process can aggressively damage AlN growth process can aggressively damage the SiC, thereby increasing SiC desorption and causing the formation of a larger step 1215. This condition can result in step 1215 being formed in any of the devices described herein and may reduce the performance of such devices. According to an example of the present disclosures, the formation of step 1215 can be inhibited, or the size of step 1215 can be reduced, by substituting nitrogen gas for hydrogen gas in the ramp up prior to the AlN growth process. Nitrogen can be less damaging to SiC than hydrogen, and may therefore result in less desorption.

The various figures and associated discussions include various aspects or features of lateral GaN superjunction transistors. The features shown in any figure, or described in any associated discussion, can be combined or mixed with features of any other figure to form examples the lateral GaN superjunction transistors described herein. In an example, the lateral GaN superjunction transistors shown in FIGS. 9-11 can correspond to or in include features any of the lateral GaN superjunction transistors shown in any of the other figures.

Example 1 is a high electron mobility transistor, comprising: a substrate layer; a transmorphically grown gallium nitride (GaN) based heterostructure overlying the substrate layer, the GaN-based heterostructure including: a channel layer of a first compound semiconductor material disposed proximate to the substrate layer; and a barrier layer of a second compound semiconductor material disposed adjacent to the channel layer and forming a two-dimensional electron gas (2DEG) at a junction between the channel layer and the barrier layer, the 2DEG having an electron concentration; and a buried implant region formed by an implanted activated dopant and disposed at least partially within the substrate layer and extending laterally from a region underlying a source terminal of the transistor to a region between a gate and drain terminals of the transistor, the buried implant region configured to modulate an electric field between the gate and drain terminals of the transistor.

In Example 2, the subject matter of Example 1 includes, wherein a concentration of the activated dopant is matched to an electron concentration of the 2DEG.

In Example 3, the subject matter of Example 2 includes, wherein the concentration of the activated dopant is matched to the electron concentration of the 2DEG so that a voltage applied between the gate and drain terminals of the transistor concurrently depletes respective concentrations of holes and electrons in overlapping regions of the implant region and the 2DEG.

In Example 4, the subject matter of Examples 2-3 includes, wherein the concentration of the activated dopant decreases laterally from a region underlying the gate terminal to a region underlying the drain terminal.

In Example 5, the subject matter of Examples 2-4 includes, wherein the buried implant region is disposed within a vertical distance of 150 to 400 nanometers of the 2DEG.

In Example 6, the subject matter of Examples 1-5 includes, the gate terminal, wherein the gate terminal includes a free-standing gate head.

In Example 7, the subject matter of Examples 1-6 includes, wherein the channel layer has a crystalline structure that exceeds a specified crystal quality threshold to determine a thickness of the heterostructure.

In Example 8, the subject matter of Example 7 includes, wherein the specified crystal quality threshold includes a rocking curve with a peak having a full width half max below 300 arc-seconds.

In Example 9, the subject matter of Examples 1-8 includes, wherein the implanted activated dopant includes aluminum, nitrogen, boron, phosphorus.

In Example 10, the subject matter of Examples 1-9 includes, wherein the GaN-based heterostructure includes an aluminum nitride nucleation layer.

In Example 11, the subject matter of Example 10 includes, wherein the aluminum nitride nucleation layer has a rocking curve with a peak having a full width half max below 100 arc-seconds.

In Example 12, the subject matter of Examples 1-11 includes, wherein the substrate includes silicon carbide.

In Example 13, the subject matter of Examples 1-12 includes, wherein the second compound semiconductor material is aluminum gallium nitride.

In Example 14, the subject matter of Examples 1-13 includes, wherein the substrate layer includes semi insulating high purity silicon carbide.

In Example 15, the subject matter of Examples 1-14 includes, a nucleation layer interposed between the channel layer and the substrate, the nucleation layer formed after a temperature ramp up with nitrogen gas.

Example 16 is a method for forming a high electron mobility transistor, the method comprising: obtaining a substrate; forming, using an ion implantation process, a buried implant region at least partially within the substrate and extending laterally from a region underlying a source of the transistor to a region between a gate and a drain of the transistor; forming a nucleation layer having a crystalline structure presenting a rocking curve with a full width half max below 100 arcseconds; forming a channel layer of a first compound semiconductor material on a surface of the nucleation layer, the channel layer having a second crystalline structure presenting a rocking curve with a peak full width half max below 250 arcseconds; forming a barrier layer of a second compound semiconductor material on a surface of the channel layer such that a two-dimensional electron gas (2DEG) is formed at a junction between the channel layer and the barrier layer.

In Example 17, the subject matter of Example 16 includes, wherein forming the nucleation layer and the forming the channel layer includes forming the nucleation layer or the forming the channel layer to have a combined height such that a vertical distance between the buried implant region and the 2DEG is between 150 and 400 nanometers.

In Example 18, the subject matter of Examples 16-17 includes, forming the buried implant region to have an activated dopant concentration that is matched to an electron concentration of the 2DEG.

In Example 19, the subject matter of Examples 16-18 includes, wherein forming the buried implant region includes: forming a p-type region having a p-type material by implanting a p-type dopant into the substrate and forming an n-type region having an n-type material by implanting an n-type dopant into the substrate.

In Example 20, the subject matter of Example 19 includes, wherein forming the n-type region includes forming the n-type region laterally adjacent to the p-type region.

In Example 21, the subject matter of Examples 19-20 includes, wherein from the n-type region includes forming the n-type region at least partially within the p-type region so that the n-type region laterally overlies a length of the p-type region.

In Example 22, the subject matter of Examples 19-21 includes, forming source using a material or a process used to form the drain, wherein the source contacts the n-type region.

In Example 23, the subject matter of Examples 16-22 includes, forming the gate having a free-standing gate head.

In Example 24, the subject matter of Examples 16-23 includes, forming the forming a nucleation layer after a temperature ramp up step with nitrogen gas.

Example 25 is a device having a high electron mobility transistor, the device comprising; a high electron mobility transistor, the high electron mobility transistor comprising: a substrate layer; a buried implant region including first and second dopants implanted within the substrate layer, the buried implant region extending laterally from a region underlying a source terminal of the transistor to a region between a gate and drain terminals of the transistor, the buried implant region configured to modulate an electric field between the gate and drain terminals of the transistor; a nucleation layer overlying the substrate and the buried implant region ; a channel layer of a first compound semiconductor material overlying the nucleation layer; and a barrier layer of a second compound semiconductor material overlying the channel layer and forming a two-dimensional electron gas (2DEG) at a first interface between the channel layer and the barrier layer; wherein the channel layer and the nucleation layer are transmorphically grown to have a lattice match at a second interface between the nucleation layer and the channel layer that enables a height of the channel layer and the nucleation layer to be smaller than a threshold vertical distance between the buried implant region and the 2DEG to enable the buried implant region to modulate an electric field between the gate and drain terminals.

In Example 26, the subject matter of Example 25 includes, wherein the nucleation layer is formed after a temperature ramp up step using nitrogen gas.

In Example 27, the subject matter of Examples 25-26 includes, any of the elements of Examples d2-d13.

Example 28 is a high electron mobility transistor, comprising: a silicon carbide substrate layer; a gallium nitride (GaN) based heterostructure overlying the substrate layer, the GaN-based heterostructure including: a channel layer of a first compound semiconductor material disposed proximate to the substrate layer; and a barrier layer of a second compound semiconductor material disposed adjacent to the channel layer and forming a two-dimensional electron gas (2DEG) at a junction between the channel layer and the barrier layer; and a buried implant region disposed at least partially within the substrate layer and extending laterally from a region underlying a source terminal of the transistor to a region between a gate and drain terminals of the transistor, the buried region having a first and second regions, the first region having a n-type material, the second region having a p-type material.

In Example 29, the subject matter of Example 28 includes, wherein the buried implant region configured to modulate an electric field between the gate and drain terminals of the transistor.

In Example 30, the subject matter of Example 29 includes, wherein the first region is more electrically conductive than the second region.

In Example 31, the subject matter of Examples 29-30 includes, wherein: the first region is configured to conduct an alternating current from the drain terminal responsive to a voltage applied between the gate terminal and the drain terminal; and the second region is configured to inhibit a turn on leakage current from the drain terminal.

In Example 32, the subject matter of Example 31 includes, wherein a breakdown voltage of the transistor is determined by a concentration of p-type dopant in the second region.

In Example 33, the subject matter of Examples 29-32 includes, wherein the first region extends laterally from the region underlying a source terminal of the transistor to the region between the gate and drain terminals of the transistor, and the second region is disposed laterally adjacent to first region between the gate terminal and the drain terminal.

In Example 34, the subject matter of Examples 29-33 includes, wherein second region extends laterally from the region underlying a source terminal of the transistor to the region between the gate and drain terminals, and the first region is disposed at least partially within the second region such that the n-type material laterally overlies a length of the second region.

In Example 35, the subject matter of Examples 29-34 includes, the source and drain terminals, wherein: the source terminal contacts the n-type material.

In Example 36, the subject matter of Examples 29-35 includes, wherein the source and drain terminals a formed using a same material.

In Example 37, the subject matter of Examples 29-36 includes, wherein the buried implant region is disposed within a vertical distance of 150 to 400 nanometers to the 2DEG.

In Example 38, the subject matter of Examples 29-37 includes, wherein a dopant concentration of the n-type material or a dopant concentration of the p-type material is matched to an electron concentration of the 2DEG.

In Example 39, the subject matter of Examples 29-38 includes, wherein a dopant concentration of the n-type material or a dopant concentration of the p-type material is matched to an electron concentration of the 2DEG so that a voltage applied between the gate and drain terminals of the transistor concurrently depletes respective concentrations of holes and electrons in overlapping regions of the buried implant region and the 2DEG.

In Example 40, the subject matter of Examples 29-39 includes, wherein a dopant concentration of the n-type material or a dopant concentration of the p-type material decreases laterally from a region underlying the gate terminal to a region underlying the drain terminal.

In Example 41, the subject matter of Examples 29-40 includes, wherein the silicon carbide substrate layer includes semi insulating high purity silicon carbide.

In Example 42, the subject matter of Examples 29-41 includes, a nucleation layer interposed between the channel layer and the substrate, the nucleation layer formed using nitrogen as a carrier gas.

Example 43 is a high electron mobility transistor, comprising: a substrate layer; a gallium nitride (GaN) based heterostructure overlying the substrate layer, the GaN-based heterostructure including: a channel layer of a first compound semiconductor material disposed proximate to the substrate layer; and a barrier layer of a second compound semiconductor material disposed adjacent to the channel layer and forming a two-dimensional electron gas (2DEG) at a junction between the channel layer and the barrier layer; and a buried implant region disposed at least partially within the substrate layer and extending laterally from a region underlying a source region of the transistor to a region between a gate and drain region of the transistor; and a floating implant region interposed between, and laterally displaced from, the buried implant region and the drain region.

In Example 44, the subject matter of Example 43 includes, wherein the buried implant region is connected to the source region and the floating implant region is capacitively coupled to the buried implant region and to the drain region.

In Example 45, the subject matter of Examples 43-44 includes, wherein the buried implant region and the floating implant region are configured to form a capacitive voltage divider to provide one or more voltage drops between the drain region and the source region.

In Example 46, the subject matter of Example 45 includes, wherein the capacitive voltage divider is configured to provide a voltage drop between the floating implant region and the buried implant region corresponding to a concentration of activated dopants in the floating implant region or a concentration of activated dopants in the buried implant region.

In Example 47, the subject matter of Examples 45-46 includes, wherein the capacitive voltage divider is configured to provide a voltage drop between the floating implant region and the buried implant region corresponding to: a size of the floating implant region or a size of the buried implant region; or a distance between the floating implant region and the buried implant region.

In Example 48, the subject matter of Examples 45-47 includes, wherein the floating implant region includes first and second floating implant regions, and the capacitive voltage divider is configured to provide a voltage drop between the first and second implant regions corresponding to a concentration of activated dopants in the floating implant region or a concentration of activated dopants in the second implant region.

In Example 49, the subject matter of Examples 45-48 includes, wherein the floating implant region includes first and second floating implant regions, and the capacitive voltage divider is configured to provide a voltage drop between the first and second implant regions corresponding to: a size of the first floating implant region or a size of the second buried implant region; or a distance between first and second floating implant regions.

In Example 50, the subject matter of Examples 44-49 includes, wherein the buried implant region is disposed within a vertical distance of 150 to 400 nanometers of the 2DEG.

In Example 51, the subject matter of Examples 44-50 includes, wherein a concentration of dopants in the buried implant region or a concentration of dopants in the floating implant region is matched to an electron concentration of the 2DEG.

In Example 52, the subject matter of Examples 44-51 includes, wherein the substrate layer includes semi insulating high purity silicon carbide.

In Example 53, the subject matter of Examples 44-52 includes, a nucleation layer interposed between the channel layer and the substrate, the nucleation layer formed after a temperature ramp up step using nitrogen gas.

Example 54 is a high electron mobility transistor, comprising: a substrate layer; a gallium nitride (GaN) based heterostructure overlying the substrate layer, the GaN-based heterostructure including: a channel layer of a first compound semiconductor material disposed proximate to the substrate layer; and a barrier layer of a second compound semiconductor material disposed adjacent to the channel layer and forming a two-dimensional electron gas (2DEG) at a junction between the channel layer and the barrier layer; and a buried implant region disposed at least partially within the substrate layer and extending laterally from a region underlying a source terminal of the transistor to a region between a gate and drain terminals of the transistor, the buried implant region being capacitively coupled to the source terminal when the transistor is switched within an indicated frequency range.

In Example 55, the subject matter of Example 54 includes, wherein the source includes first and second regions, the first region extend laterally over a portion of the buried implant region, the second region connected to the buried implant region by a source contact.

In Example 56, the subject matter of Example 55 includes, wherein an impedance between the buried implant region and the first region is lower than an impedance between the buried implant region and the second region when the transistor is operated within the indicated frequency range.

In Example 57, the subject matter of Examples 54-56 includes, wherein the source is disposed at least partially within the barrier layer.

In Example 58, the subject matter of Example 57 includes, wherein the buried implant region is disposed within 200 nanometers of the source terminal.

In Example 59, the subject matter of Examples 54-58 includes, wherein the buried implant region is configured to operate a field plate when the transistor is operated within the indicated frequency range.

In Example 60, the subject matter of Examples 54-59 includes, wherein a concentration of dopants in the buried implant region is matched to an electron concentration of the 2DEG.

In Example 61, the subject matter of Examples 54-60 includes, wherein the substrate layer includes semi insulating high purity silicon carbide.

In Example 62, the subject matter of Examples 54-61 includes, a nucleation layer interposed between the channel layer and the substrate, the nucleation layer formed after a temperature ramp up step using nitrogen gas.

Example 63 is at least one machine-readable medium including instructions that, when executed by processing circuitry, cause the processing circuitry to perform operations to implement of any of Examples 1-62.

Example 64 is an apparatus comprising means to implement of any of Examples 1-62.

Example 65 is a system to implement of any of Examples 1-62.

Example 66 is a method to implement of any of Examples 1-62.

As used herein, the term epitaxy refers to the formation (e.g., deposition or growth) of a crystalline layer or film on the surface of crystalline substrate, whereby the formed layer takes on the crystal structure and lattice properties of the substrate. Epitaxy may be used in semiconductor device fabrication to form thin-films of single crystals. Epitaxy may be performed in the vapor phase, liquid phase, or solid phase. In some embodiments, molecular beam epitaxy ("MBE") may be used for growing semiconductor crystals from elements in groups 13 and 15, although it should be appreciated that other forms of epitaxy may be used with the techniques described herein.

The present disclosure uses the terms switch, switching device, or switching element synonymously. A switch, switching device, or switching element can include one or more electronically controlled switches such as an electromechanical switch, transistor, or other controllable semiconductor device.

As used herein, a conductivity type of a material refers to the type of the majority charge carries in the material. The conductivity types discussed herein are n-type, such as to corresponding to a majority electron charge carrier, or p-type, such as to correspond to a majority hole charge carrier. The indicator of the conductivity type of a material (e.g., "n" or "p") can include a positive sign (e.g., "+") or a negative sign (e.g., "-") to indicate a concentration of dopants or majority charge carriers in the material relative to a concentration of dopants or majority charge carriers in another material. Materials having positive conductivity type indicators have higher dopant or charge carrier concentrations than materials with negative conductivity type indicators. In an example, an n+ layer has a higher dopant concentration than an n layer, which has a higher dopant concentration than an n- layer.

The substrates, device layers, or device regions are described herein with references to specific conductivity types. It should be appreciated, however, that the conductivity type of such substrates, devices layers, or device regions can be switched to an opposite conductivity type or polarity, such as to fabricate a device with the opposite conductivity type. In an example, the conductivity type of the substrates, devices layers, or device regions of n-type MOSFETs (e.g., NMOS devices) can be inverted or switched to corresponding opposite conductivity types to fabricate p-type MOSFETs (e.g., PMOS devices).

The above detailed description includes references to the accompanying drawings, which form a part of the detailed description. The drawings show, by way of illustration, specific embodiments in which the invention may be practiced. These embodiments are also referred to herein as "examples." Such examples may include elements in addition to those shown or described. However, the present inventors also contemplate examples in which only those elements shown or described are provided. Moreover, the present inventors also contemplate examples using any combination or permutation of those elements shown or described (or one or more aspects thereof), either with respect to a particular example (or one or more aspects thereof), or with respect to other examples (or one or more aspects thereof) shown or described herein.

In the event of inconsistent usages between this document and any documents so incorporated by reference, the usage in this document controls.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In this document, the terms "including" and "in which" are used as the plain-English equivalents of the respective terms "comprising" and "wherein." Also, in the following claims, the terms "including" and "comprising" are open-ended, that is, a system, device, article, composition, formulation, or process that includes elements in addition to those listed after such a term in a claim are still deemed to fall within the scope of that claim. Moreover, in the following claims, the terms "first," "second," and "third," etc. are used merely as labels, and are not intended to impose numerical requirements on their objects.

Method examples described herein may be machine or computer-implemented at least in part. Some examples may include a computer-readable medium or machine-readable medium encoded with instructions operable to configure an electronic device to perform methods as described in the above examples. An implementation of such methods may include code, such as microcode, assembly language code, a higher-level language code, or the like. Such code may include computer readable instructions for performing various methods. The code may form portions of computer program products. Further, in an example, the code may be tangibly stored on one or more volatile, non-transitory, or non-volatile tangible computer-readable media, such as during execution or at other times. Examples of these tangible computer-readable media may include, but are not limited to, hard disks, removable magnetic disks, removable optical disks (e.g., compact discs and digital video discs), magnetic cassettes, memory cards or sticks, random access memories (RAMs), read only memories (ROMs), and the like.

The above description is intended to be illustrative, and not restrictive. For example, the above-described examples (or one or more aspects thereof) may be used in combination with each other. Other embodiments may be used, such as by one of ordinary skill in the art upon reviewing the above description. The Abstract is provided to comply with 37 C.F.R. §1.72(b), to allow the reader to quickly ascertain the nature of the technical disclosure. It is submitted with the understanding that it will not be used to interpret or limit the scope or meaning of the claims. Also, in the above Detailed Description, various features may be grouped together to streamline the disclosure. This should not be interpreted as intending that an unclaimed disclosed feature is essential to any claim. Rather, inventive subject matter may lie in less than all features of a particular disclosed embodiment. Thus, the following claims are hereby incorporated into the Detailed Description as examples or embodiments, with each claim standing on its own as a separate embodiment, and it is contemplated that such embodiments may be combined with each other in various combinations or permutations. The scope of the invention should be determined with reference to the appended claims, along with the full scope of equivalents to which such claims are entitled.

## Claims

1. A device having a high electron mobility transistor, the device comprising:
the high electron mobility transistor, the high electron mobility transistor comprising:
a substrate layer;
a transmorphically grown gallium nitride (GaN) based heterostructure overlying the substrate layer, the GaN-based heterostructure including:
a channel layer of a first compound semiconductor material disposed proximate to the substrate layer; and
a barrier layer of a second compound semiconductor material disposed adjacent to the channel layer and forming a two-dimensional electron gas (2DEG) at a junction between the channel layer and the barrier layer, the 2DEG having an electron concentration; and
a buried implant region formed by an implanted activated dopant and disposed at least partially within the substrate layer and extending laterally from a region underlying a source terminal of the transistor to a region between a gate and drain terminals of the transistor, the buried implant region configured to modulate an electric field between the gate and drain terminals of the transistor.

2. The device of claim 1, wherein a concentration of the activated dopant is matched to an electron concentration of the 2DEG.

3. The device of claim 2, wherein the concentration of the activated dopant is matched to the electron concentration of the 2DEG so that a voltage applied between the gate and drain terminals of the transistor concurrently depletes respective concentrations of holes and electrons in overlapping regions of the implant region and the 2DEG.

4. The device of claim 2 or claim 3, wherein the concentration of the activated dopant decreases laterally from a region underlying the gate terminal to a region underlying the drain terminal.

5. The device of any of claims 2 to 4, wherein the buried implant region is disposed within a vertical distance of 150 to 400 nanometers of the 2DEG.

6. The device of any preceding claim, wherein the channel layer has a crystalline structure that exceeds a specified crystal quality threshold to determine a thickness of the heterostructure, and
wherein optionally the specified crystal quality threshold includes a rocking curve with a peak having a full width half max below 300 arc-seconds.

7. The device of any preceding claim, wherein the GaN-based heterostructure includes an aluminum nitride nucleation layer, and wherein the aluminum nitride nucleation layer has a rocking curve with a peak having a full width half max below 100 arc-seconds.

8. The device of any preceding claim, further comprising at least one of:
(a) the gate terminal, wherein the gate terminal includes a free-standing gate head;
(b) a nucleation layer interposed between the channel layer and the substrate, the nucleation layer formed after a temperature ramp up with nitrogen gas.

9. A method for forming a high electron mobility transistor, the method comprising:
obtaining a substrate;
forming, using an ion implantation process, a buried implant region at least partially within the substrate and extending laterally from a region underlying a source of the transistor to a region between a gate and a drain of the transistor;
forming a nucleation layer having a crystalline structure presenting a rocking curve with a full width half max below 100 arcseconds;
forming a channel layer of a first compound semiconductor material on a surface of the nucleation layer, the channel layer having a second crystalline structure presenting a rocking curve with a peak full width half max below 250 arcseconds; and
forming a barrier layer of a second compound semiconductor material on a surface of the channel layer such that a two-dimensional electron gas (2DEG) is formed at a junction between the channel layer and the barrier layer.

10. The method of claim 9, wherein forming the nucleation layer and the forming the channel layer includes forming the nucleation layer or the forming the channel layer to have a combined height such that a vertical distance between the buried implant region and the 2DEG is between 150 and 400 nanometers.

11. The method of claim 9 or claim 10, wherein forming the buried implant region includes:
forming a p-type region having a p-type material by implanting a p-type dopant into the substrate and forming an n-type region having an n-type material by implanting an n-type dopant into the substrate.

12. The method of claim 11, wherein forming the n-type region includes forming the n-type region laterally adjacent to the p-type region.

13. The method of claim 11 or claim 12, wherein forming the n-type region includes forming the n-type region at least partially within the p-type region so that the n-type region laterally overlies a length of the p-type region.

14. The method of any of claims 9 to 13, further comprising at least one of:
(a) forming the gate having a free-standing gate head;
(b) forming the forming a nucleation layer after a temperature ramp up step with nitrogen gas;
(c) forming the buried implant region to have an activated dopant concentration that is matched to an electron concentration of the 2DEG.

15. A device having a high electron mobility transistor, the device comprising:
the high electron mobility transistor, the high electron mobility transistor comprising:
a substrate layer;
a buried implant region including first and second dopants implanted within the substrate layer, the buried implant region extending laterally from a region underlying a source terminal of the transistor to a region between a gate and drain terminals of the transistor, the buried implant region configured to modulate an electric field between the gate and drain terminals of the transistor;
a nucleation layer overlying the substrate and the buried implant region;
a channel layer of a first compound semiconductor material overlying the nucleation layer; and
a barrier layer of a second compound semiconductor material overlying the channel layer and forming a two-dimensional electron gas (2DEG) at a first interface between the channel layer and the barrier layer;
wherein the channel layer and the nucleation layer are transmorphically grown to have a lattice match at a second interface between the nucleation layer and the channel layer that enables a height of the channel layer and the nucleation layer to be smaller than a threshold vertical distance between the buried implant region and the 2DEG to enable the buried implant region to modulate an electric field between the gate and drain terminals; and
wherein optionally the nucleation layer is formed after a temperature ramp up step using nitrogen gas.
